# EUROPEAN PATENT SPECIFICATION

(11) **EP 0 529 578 B1**
(45) Date of publication and mention of the grant of the patent: **31.01.1996**
(21) Application number: 92114445.7
(22) Date of filing: 25.08.1992
(51) Int. Cl.: H05K 3/20, H05K 3/40

(54) **Semi-additive circuitry with raised features using formed mandrels**
Semi-additive elektrische Schaltungen mit erhöhten Einzelheiten unter Verwendung geformter Matrizen
Circuits électriques semi-additifs avec des particularités élevées utilisant des matrices formées

(30) Priority: 26.08.1991 US 750842; 30.08.1991 US 753400
(43) Date of publication of application: 03.03.1993
(73) Proprietor: Hughes Aircraft Company, Los Angeles, California 90045-0066 (US)
(72) Inventor: Crumly, William R., Anaheim, California 90080-0028 (US); Schreiber, Christopher M., San Clemente, California 92672 (US); Swarbrick, David B., El Toro, California 92630 (US)
(74) Representative: Weller, Wolfgang, Dr.rer.nat.

(56) References cited:
- CH-A- 353 417
- GB-A- 2 049 297
- US-A- 3 350 250
- US-A- 4 125 441
- US-A- 4 564 423
- US-A- 4 584 039
- PATENT ABSTRACTS OF JAPAN vol. 012, no. 425 (E-681)10 November 1988 & JP-A-63 164 327

## Description

### BACKGROUND OF THE INVENTION

### 1. Field of the Invention

The present invention relates to fabrication of electrical circuits, and more particularly concerns fabrication of circuits employing mandrels and semi-additive processes for making circuits having raised features.

### 2. Description of Related Art

US-A-3 350 250 discloses a method for constructing printed wiring circuitry having protruding electrical conductors which extend through, and project beyond the substrate. The protruding conductors are constructed by depositing electrically conductive material on a stainless plate having protuberances or frusto-conical holes.

In a prior application of William R. Crumly, Christopher M. Schreiber and Haim Feigenbaum for Three-Dimensional Electroformed Circuitry, US-A-5 197 184 (published after the priority date of the present application), assigned to the assignee of the present application, there are described techniques for fully additive forming of electrical circuits having integral raised features. In general, the processes described in the prior application include the use of a stainless steel mandrel in which are formed raised features projecting from the mandrel surface, either downwardly into the mandrel or upstanding from the mandrel surface. A pattern of grooves in the form of a negative of a circuit to be fabricated is formed in the surface of the mandrel and filled with Teflon or other non-conductive material and the desired pattern of circuit traces is then electrodeposited onto the mandrel surface between the areas of Teflon and into the depressions or over the post of the three dimensional mandrel features. The use of Teflon embedded in groves within the mandrel to define the circuit traces limits the minimum size of circuit traces that can be formed, because, as the circuit trace is additively formed, as by electroplating, a plated material plates up laterally on either side at the same time that it plates up vertically above the surface. Accordingly, for example, to obtain a trace 1 mil thick and 4 mils wide, the conductive pattern line width on the mandrel can be no more than 2 mils in width, because the plating of a 1 mil thickness also plates outwardly on either side to one 1 mil (1 mil = 25.4µm). Thus, fabrication of very fine circuit trace lines is limited.

If the Teflon pattern is deposited on the surface of the stainless steel mandrel instead of in grooves, finer circuit trace features and widths can be obtained, but difficulties are encountered in treating the mandrel surface to achieve satisfactory adherence of the Teflon to the stainless steel mandrel surface.

The fully additive techniques described in the above-identified patent application have many advantages. After the mandrel has been made there is no need to do any further printing or photo operations. All registration of the raised features with the circuit traces is completed, and there are no subsequent registration problems. Further, there are no further photolithographic operations, and much manual labor in the use of the completed mandrels for production of circuits is eliminated. Nevertheless the mandrel itself is relatively complex and expensive and time consuming to produce, and, therefore, finds maximum utility in relatively long production runs where rapid fabrication of the first prototype and production items is not essential. Thus, the fully additive mandrel for making circuits with raised features is most useful for long production runs where time of initial production is of lesser importance, but such mandrels are not as readily applicable for production of raised feature circuits in smaller quantities where the first prototype must be available in a short time.

Accordingly, it is an object of the present invention to provide for production of electrical circuits with raised features by methods that avoid or minimize above mentioned problems.

### SUMMARY OF THE INVENTION

According to one aspect of the present invention, there are provided methods of making a multi-layer electric circuit having raised features as defined in independent claims 1 and 8.

According to another aspect of the invention, there is provided a reusable mandrel for forming a raised feature multi-layer electric circuit as defined in claim 5.

In carrying out principles of the present invention in accordance with a preferred embodiment thereof a simple, more readily formed mandrel is employed and semi-additive rather than fully additive techniques are used with the mandrel for making the circuit with its raised features. The electrically conductive mandrel is provided with a pattern of dimples or depressions and is then coated with a very thin coat of electrically conductive material. Thereafter a pattern of resist is formed on the coating, and the circuit traces are electroformed on the mandrel, while, at the same time, forming the raised features in the mandrel depressions. After removal of the resist, a dielectric and adhesive layer is bonded to the electroformed circuitry and raised features, after which the lamination of dielectric and circuitry with raised features may be removed from the mandrel, ready for removal of the coating and application of coverlay laminations.

### BRIEF DESCRIPTION OF THE DRAWINGS

In the accompanying drawings:

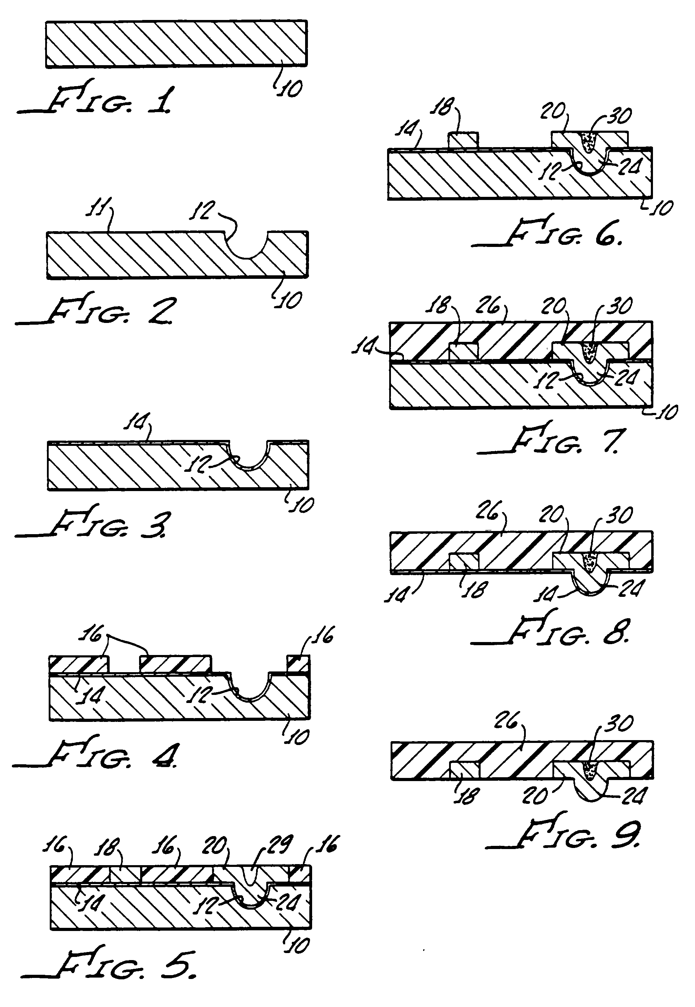

FIGS. 1 through 9 illustrate several steps in the manufacture of multi-layer circuitry embodying the principles of the present invention.

### DETAILED DESCRIPTION OF THE PREFERRED EMBODIMENT

According to principles of the present invention, an improved mandrel is used which can be fabricated rapidly and requires no permanently affixed Teflon or other non-conductive pattern. Thus the mandrel is simpler and faster to make and is also more durable.

As illustrated in FIG. 1, a stainless steel plate 10 forms a mandrel having a forming surface 11 in which is provided one or a plurality of depressions or dimples 12, as shown in FIG. 2, which will define raised features of the resulting circuitry.

As shown in FIG. 3, the mandrel and its depression or depressions is then coated with a copper coating 14, typically referred to as flash plated, which covers the entire surface of the mandrel, including the surface of the depressions. The flash plated copper is applied by electroplating or other known techniques and provides a thin conductive coating that prevents the adhesive (that will be used to laminate the circuit substrate) from adhering to the mandrel surface. Flash plating is a conventional electrolytic plating formed in a very short or momentary operation so that only a very thin plating coat is provided. The flash plated coat is very thin compared to the thickness of the electrical circuit traces that are made. For example, for a circuit trace of 1 1/2 mil thickness, a flash plating of copper on the mandrel will have a thickness of .01 to 0.2 mils (1 mil = 25.4µm). The thin flash plating is employed because it can be relatively easily released from the stainless steel mandrel, and, in addition, may be readily removed from the lamination after separation from the mandrel by a flash etching, which is a very short time or momentary etching process. Obviously, other methods for coating the mandrel with a very thin coat of conductive material that is readily separable from the mandrel and which can be readily removed from the completed circuit traces may be employed in the place of the electrolytic flash plating. Such methods may include sputtering, vapor deposition and electroless plating. If deemed necessary or desirable, the mandrel may be made of a non-electrically conductive material because the thin electrically conductive coating itself enables the additive electroplating of the circuit traces and raised features. The coating, for a dielectric mandrel, can be applied by electroless plating, sputtering, or additional conductive particles in solution. No pattern of non-conductive material, such as Teflon, is permanently affixed to the mandrel. Instead, the flash plated copper is coated with a photoresist, which is then optically exposed through a mask defining a pattern of the desired circuit and developed. The photoresist that has not been polymerized is then removed to leave the partially completed assembly in the configuration illustrated in FIG. 4. As shown, the flash plated copper coating 14 now bears a pattern 16 of photoresist that is a negative pattern of the circuit trace pattern to be fabricated with this mandrel.

The mandrel assembly of FIG. 4 is then subjected to a suitable additive electroforming process, such as, for example, electroplating, to plate up copper traces, including trace 18 and a raised feature pad 20, including a raised feature 24 in the depression 12, as shown in FIG. 5. The copper traces are plated directly onto those portions of the flash plated copper coating 14 that are not covered by the negative pattern of developed photoresist 16. Thus the plating process simultaneously forms both the circuit traces and the raised features. The raised features 24 are partly hollow, having a depression 29 (FIG. 5). If deemed necessary or desirable, the depression 29 formed in the electroplated raised feature 24 may be filled with a solid material 30 (FIG. 6) by placing a dollop of epoxy in the depression and then allowing the epoxy to cure.

The photoresist 16 is then stripped to leave the circuit traces and raised features 18,20, and 24 on the flash plated copper coating which is still on the mandrel, as shown in FIG. 6. Now a layer of a suitable dielectric and adhesive, such as, for example, a layer 26 of Kapton and an adhesive, are laminated to the mandrel assembly with the traces and circuit features thereon under suitable high temperatures and pressures. This causes the Kapton and adhesive to flow into the spaces between the traces and thereby contact traces and pads on three sides. Only that side of the traces and pads that is direct in contact with the flash plated copper on the mandrel is not contacted by the adhesive/Kapton substrate 26.

The assembly now appears as in FIG. 7, including the mandrel 10, the flash plated copper 14, traces, pads and features 18,20 and 24, and the Kapton/adhesive substrate 26.

The circuit assembly of FIG. 7 is then removed from the mandrel. Because only the flash plated copper contacts the mandrel, this may be readily separated, and no adhesive of the substrate 26 is in contact with the mandrel. Thus it will be seen that because the mandrel has been initially coated with the protective layer of the flash plated copper 14, the assembly of dielectric/adhesive substrate and circuit traces and raised features can be readily separated from the mandrel, together with the flash plated copper coating. This separated sub-assembly is shown removed from the mandrel in FIG. 8.

Then, as indicated in FIG. 9, the flash plated copper coating, which covers the entire lower (as viewed in FIG. 8) surface of the assembly of FIG. 8, is removed by a flash etching process to yield the finished or substantially finished sub-assembly of FIG. 9. The sub-assembly of FIG. 9 is ready for the coverlay lamination, which comprises the standard process for covering at least the side of the sub-assembly bearing the conductive traces with an insulative coverlay.

If deemed necessary or desirable, the removal of the flash plated copper coating may be controlled by a "stop" layer of gold, which will prptect the thicker copper circuit during flash etch removal of the flash plated copper. To this end, the flash coated mandrel with its photolithographically defined resist pattern 16 in place, as shown in FIG. 4, may be plated with a thin layer of gold, about 0.00006 inches thick, upon which the circuitry 18 and 20 will be plated (1 inch = 25.4 mm). This patterned gold "stop" layer allows the flash plated copper to be removed by the flash etching from the dielectric, but protects the copper circuit.

The above described semi-additive processes for making circuitry with raised features have many advantages over the fully additive processes described in the above identified co-pending application. The manufacture of the flash plated mandrel is much simpler, cheaper and considerably faster, as no elaborate processes need be undertaken to place a permanent coating of Teflon or other non-conductive material thereon. Accordingly, such mandrels may readily be made in different configurations for manufacture of circuit traces of different patterns. The simplified fabrication of the mandrel results in faster availability of the mandrel for manufacture of the circuitry so that a mandrel made for use in the semi-additive processes described herein may be made one day and will be available for making parts the next day, whereas parts may not be available nearly as soon from a mandrel made according to the fully additive techniques described in the above application. Further, because of the simplicity and lower cost of making the flash plated mandrel, it is considerably cheaper and is economically feasible for use in smaller production runs.

It will be seen that the method of circuit fabrication described herein incorporates a more rugged, considerably simpler mandrel for electroplating, and still employs primarily additive techniques, such as electroplating, for creating circuit patterns and integral raised features.

## Claims

1. Method of making a multi-layer electric circuit having raised features (24) comprising the steps of:
forming a reusable mandrel having at least one depression (12) therein,
coating said mandrel and depression (12) with an electrically conductive material (14) such that said coating (14) is readily separable from said mandrel and depression (12),
additively forming a pattern of circuit traces (18, 20) on said coating (14) and in said depression (12), including forming a raised feature (24) that projects from the plane of said circuit traces (18, 20),
laminating a dielectric substrate (26) to said traces (18, 20) and depression (12), whereby said coating (14) prevents said substrate (26) from adhering to said mandrel, and
removing said traces (18, 20) and substrate (26) and coating (14) from said mandrel.

2. Method according to claim 1, characterized in that said step of additively forming a pattern of circuit traces (18, 20) comprises the steps of applying a pattern of resist (16) to said coating (14), and electroforming conductive material (18) on said mandrel and coating (14) between elements of said resist pattern.

3. Method according to claim 1 or claim 2, characterized in that said step of coating said mandrel comprises flash plating, wherein said step of additively forming comprises electroplating, and including removing said coating (14) after said traces (18, 20) and substrate (26) are removed from said mandrel.

4. Method according to any of claims 1 - 3, characterized by the step of applying a stop coat to said pattern of circuit traces (18, 20) for protection of said circuit traces (18, 20) during said step of removing said coating (14).

5. Reusable mandrel for forming a raised feature (24) multi-layer electric circuit by electrodeposition, comprising:
a body (10) having a forming surface (11),
a depression (12) in said surface (11) configured and arranged to form a raised feature (24) of a circuit to be formed on the mandrel,
characterized by
an electrically conductive coating (14) on said forming surface (11) and depression (12), said coating (14) being readily separable from said surface (11).

6. Mandrel according to claim 5, characterized by a pattern of non-conductive material (16) formed on said coating (14).

7. Mandrel according to claim 5, characterized by a pattern of photoresist (16) on said coating (14), said photoresist (16) having a pattern that is the negative of a pattern of circuit traces (18, 20), whereby a pattern of circuit traces (18, 20) having a portion extending into said depression (12) may be electrodeposited on said coating (14) and laminated to a non-conductive substrate (26) by means of an adhesive which does not contact said forming surface (11).

8. Method for making a multi-layer electric circuit having raised features (24) comprising the steps of:
forming a reusable mandrel having a forming surface (11) and a raised mandrel feature (12),
applying to said surface (11) and feature (12) an electrically conductive coating (14), such that said coating (14) is readily separable from said mandrel and feature (12),
additively forming a pattern of circuit traces (18, 20) on said coating (14),
additively depositing a conductive material raised feature (24) on said mandrel feature (12),
adhesively securing a substrate (26) to said circuit traces (18, 20) and conductive material raised feature (24), whereby said coating (14) prevents said substrate (26) from adhering to said mandrel,
removing said substrate (26), circuit traces (18, 20), conductive material raised feature (24) and coating (14) from said mandrel, and
removing said coating (14) from said traces (18, 20), conductive material raised feature (24) and substrate (26).

9. Method according to claim 8, characterized in that said mandrel includes a depression (12) shaped to form said conductive material raised feature (24), wherein said step of applying a coating (14) comprises applying the coating (14) to said depression (12), and wherein said step of forming a pattern of circuit traces (18, 20) comprises forming a part of said traces (18, 20) in said depression (12).

10. Method according to claim 8, characterized in that said step of forming a pattern of traces (18, 20) comprises electrodepositing a pattern of conductive material on said coating (14).

## Patentansprüche

1. Verfahren zur Herstellung einer mehrlagigen elektrischen Schaltung mit erhabenen Elementen (24), mit den Schritten:
- Ausbilden eines wiederverwendbaren Formkernes, in dem sich wenigstens eine Vertiefung (12) befindet,
- Beschichten des Formkernes und der Vertiefung (12) mit einem elektrisch leitenden Material (14) derart, daß die Beschichtung (14) leicht von dem Formkern und der Vertiefung (12) trennbar ist,
- additives Ausbilden von einem Muster von Schaltungsbahnen (18, 20) auf der Beschichtung (14) und in der Vertiefung (12), wobei dieser Schritt das Ausbilden eines erhabenen Elementes (24) umfaßt, das von der Ebene der Schaltungsbahnen (18, 20) vorsteht,
- Aufbringen eines dielektrischen Substrates (26) auf die Bahnen (18, 20) und die Vertiefung (12), wobei die Beschichtung (14) es verhindert, daß das Substrat (26) an dem Formkern anhaftet, und
- Entfernen der Bahnen (18, 20) und des Substrates (26) sowie der Beschichtung (14) von dem Formkern.

2. Verfahren nach Anspruch 1, dadurch gekennzeichnet, daß der Schritt des additiven Ausbildens von einem Muster von Schaltungsbahnen (18, 20) die Schritte des Auftragens eines Musters aus einer Schutzabdeckung (16) auf die Beschichtung (14) und des elektrischen Abscheidens von leitfähigem Material (18) auf den Formkern und die Beschichtung (14) zwischen Elemente des Musters der Schutzabdeckung umfaßt.

3. Verfahren nach Anspruch 1 oder Anspruch 2, dadurch gekennzeichnet, daß der Schritt der Beschichtung des Formkernes eine Anschlaggalvanisierung umfaßt, wobei der Schritt der additiven Ausbildung ein elektrisches Abscheiden beinhaltet, und den Schritt des Entfernens der Beschichtung (14) umfaßt, nachdem die Bahnen (18, 20) und das Substrat (26) von dem Formkern entfernt wurden.

4. Verfahren nach einem der Ansprüche 1 bis 3, gekennzeichnet durch den Schritt des Auftragens einer Stopschicht auf das Muster von Schaltungsbahnen (18, 20), um die Schaltungsbahnen (18, 20) während des Schrittes des Entfernens der Beschichtung (14) zu schützen.

5. Wiederverwendbarer Formkern zur Ausbildung einer ein erhabenes Element (24) aufweisenden mehrlagigen elektrischen Schaltung durch galvanische Metallabscheidung, mit:
- einem Körper (10) mit einer formenden Oberfläche (11),
- einer Vertiefung (12) in der Oberfläche (11), wobei die Vertiefung so ausgebildet und angeordnet ist, daß sie ein erhabenes Merkmal (24) einer auf dem Formkern auszubildenden Schaltung bildet,
gekennzeichnet durch eine elektrisch leitende Beschichtung (14) auf der formenden Oberfläche (11) und in der Vertiefung (12), wobei die Beschichtung (14) leicht von der Oberfläche (11) trennbar ist.

6. Formkern nach Anspruch 5, gekennzeichnet durch ein Muster aus nicht leitendem Material (14), das auf der Beschichtung (14) ausgebildet ist.

7. Formkern nach Anspruch 5, gekennzeichnet durch ein Muster von Photoresist (16) auf der Beschichtung (14), wobei der Photoresist (16) ein Muster aufweist, das das Negativ eines Musters von Schaltungsbahnen (18, 20) ist, wobei galvanisch ein Muster von Schaltungsbahnen (18, 20) mit einem sich in die Vertiefung (12) erstreckenden Bereich auf der Beschichtung (14) abgeschieden und mittels eines Klebers, der die formende Oberfläche (11) nicht berührt, mit einem nicht leitenden Substrat (26) verbunden werden kann.

8. Verfahren zur Herstellung einer mehrlagigen elektrischen Schaltung mit erhabenen Elementen (24), mit den Schritten:
- Ausbilden eines wiederverwendbaren Formkernes mit einer formenden Oberfläche (11) und einem Formkernelement (12) für das erhabene Element,
- Auftragen einer elektrisch leitfähigen Beschichtung (14) auf die Oberfläche (11) und das Element (12), so daß die Beschichtung (14) leicht von dem Formkern und dem Element (12) trennbar ist,
- additives Ausbilden von einem Muster von Schaltungsbahnen (18, 20) auf der Beschichtung (14),
- additives Ablagern eines erhabenen Elementes (24) aus leitfähigem Material auf dem Formkernelement (12),
- anhaftendes Anbringen eines Substrates (26) auf den Schaltungsbahnen (18, 20) und dem erhabenen Element (24) aus leitfähigem Material, wobei die Beschichtung (14) es verhindert, daß das Substrat (26) an dem Formkern anhaftet,
- Entfernen des Substrates (26), der Schaltungsbahnen (18, 20), des erhabenen Elementes (24) aus leitfähigem Material und der Beschichtung (14) von dem Formkern, und
- Entfernen der Beschichtung (14) von den Schaltungsbahnen (18, 20), dem erhabenen Element (24) aus leitfähigem Material und dem Substrat (26).

9. Verfahren nach Anspruch 8, dadurch gekennzeichnet, daß der Formkern eine Vertiefung (12) umfaßt, die so geformt ist, daß sie das erhabene Element (24) aus leitfähigem Material formt, wobei der Schritt des Auftragens einer Beschichtung (14) das Auftragen der Beschichtung (14) in die Vertiefung (12) umfaßt, und wobei der Schritt des Ausbildens eines Musters von Schaltungsbahnen (18, 20) das Ausbildens eines Teiles der Bahnen (18, 20) in der Vertiefung (12) umfaßt.

10. Verfahren nach Anspruch 8, dadurch gekennzeichnet, daß der Schritt des Ausbildens von einem Muster von Bahnen (18, 20) die galvanische Abscheidung eines Musters von leitfähigem Material auf der Beschichtung (14) umfaßt.

## Revendications

1. Procédé de fabrication d'un circuit électrique multicouche ayant des éléments en relief (24), comprenant les étapes suivantes :
on forme une matrice réutilisable dans laquelle se trouve au moins une dépression (12),
on revêt cette matrice et cette dépression (12) avec un matériau conducteur de l'électricité (14), de façon que ce revêtement (14) soit aisément séparable de la matrice et de la dépression (12),
on forme de façon additive un motif de pistes de circuit (18, 20) sur le revêtement (14) et dans la dépression (12), cette opération comprenant la formation d'un élément en relief (24) qui fait saillie à partir du plan des pistes de circuit (18, 20),
on applique un substrat diélectrique (26) sur les pistes (18, 20) et la dépression (12), le revêtement (14) empêchant la substrat (26) d'adhérer à la matrice, et
on retire de la matrice les pistes (18, 20) et le substrat (26) ainsi que le revêtement (14).

2. Procédé selon la revendication 1, caractérisé en ce que l'étape de formation additive d'un motif de pistes de circuit (18, 20) comprend les étapes qui consistent à appliquer un motif de matière de réserve (16) au revêtement (14), et à former un matériau conducteur (18), par électrodéposition, sur la matrice et le revêtement (14), entre des éléments du motif de matière de réserve.

3. Procédé selon la revendication 1 ou 2, caractérisé en ce que l'étape de revêtement de la matrice comprend la réalisation d'un dépôt flash, dans lequel l'étape de formation additive comprend une opération d'électrodéposition, et comporte l'enlévement du revêtement (14) après que les pistes (18, 20) et le substrat (26) ont été retirés de la matrice.

4. Procédé selon l'une quelconque des revendications 1-3, caractérisé par l'étape consistant à appliquer un revêtement d'arrêt au motif de pistes de circuit (18, 20), pour la protection des pistes de circuit (18, 20) pendant l'étape d'enlèvement du revêtement (14).

5. Matrice réutilisable pour former par électrodéposition un circuit électrique multicouche comportant un élément en relief (24), comprenant :
un corps (10) comportant une surface de formage (11),
une dépression (12) dans cette surface (11), dont la configuration et la disposition sont prévues pour former un élément en relief (24) d'un circuit à former sur la matrice, caractérisée par
un revêtement (14) électriquement conducteur sur la surface de formage (11) et la dépression (12), ce revêtement (14) étant aisément séparable de ladite surface (11).

6. Matrice selon la revendication 5, caractérisée par un motif de matériau non conducteur (16) formé sur le revêtement (14).

7. Matrice selon la revendication 5, caractérisée par un motif de matière de réserve photosensible (16) sur le revêtement (14), cette matière de réserve photosensible (16) ayant un motif qui est le négatif d'un motif de pistes de circuit (18, 20), grâce à quoi un motif de pistes de circuit (18, 20) ayant une partie qui s'étend à l'intérieur de la dépression (12) peut être formé par électrodéposition sur le revêtement (14) et appliqué sur un substrat non conducteur (26) au moyen d'un adhésif qui ne vient pas en contact avec la surface de formage (11).

8. Procédé pour fabriquer un circuit électrique multicouche ayant des éléments en relief (23), comprenant les étapes suivantes :
on forme une matrice réutilisable ayant une surface de formage (11) et un élément de matrice en relief (12),
on applique à la surface (11) et à l'élément (12) un revêtement (14) électriquement conducteur, de façon que ce revêtement (14) soit aisément séparable de la matrice et de l'élément (12),
on forme de façon additive un motif de pistes de circuit (18, 20) sur le revêtement (14),
on dépose de façon additive sur l'élément (12) de la matrice, un élément en relief (24) en un matériau conducteur,
on fixe un substrat (26), de façon adhésive, sur les pistes de circuit (18, 20) et l'élément en relief (24) en un matériau conducteur, grâce à quoi le revêtement (14) empêche le substrat (26) d'adhérer à la matrice,
on retire de la matrice le substrat (26), les pistes de circuit (18, 20), l'élément en relief (24) en un matériau conducteur et le revêtement (14), et
on retire le revêtement (14) des pistes (18, 20), de l'élément en relief (24) en un matériau conducteur et du substrat (26).

9. Procédé selon la revendication 8, caractérisé en ce que la matrice comprend une dépression (12) ayant une forme prévue pour former l'élément en reliefs (24) en un matériau conducteur, dans lequel l'étape d'application d'un revêtement (14) comprend l'application du revêtement (14) à la dépression (12), et dans lequel l'étape de formation d'un motif de pistes de circuit (18, 20) comprend la formation d'une partie de ces pistes (18, 20) dans la dépression (12).

10. Procédé selon la revendication 8, caractérisé en ce que l'étape de formation d'un motif de pistes (18, 20) comprend l'électrodéposition d'un motif de matériau conducteur sur le revêtement (14).
